# EUROPEAN PATENT APPLICATION

(11) **EP 1 187 345 A2**
(43) Date of publication of application: **13.03.2002**
(21) Application number: 01203146.4
(22) Date of filing: 20.08.2001
(51) Int. Cl.: H04B 1/034

(54) **Remote signalling transmitter for use in various vehicle systems**

(30) Priority: 23.08.2000 US 227418 P
(71) Applicant: Siemens Automotive Corporation, Auburn Hills, Michigan 48326-2980 (US)
(72) Inventor: Reimus, David J., Warren, Michigan 48091 (US)
(74) Representative: Allen, Derek

(57) **Abstract**

The invention relates to a remote signaling system (20), which includes a transmitter (27) having an oscillator (30) portion. The transmitter (27) comprises a transistor (34), with an antenna (32) of the transmitter (27) is directly coupled to the emitter (40) of the transistor (34). With this connection, transmitter (27) efficiency and reliability is increased without introducing additional cost into the system (20). In one example, the remote signaling system (20) is a transmitter (27) for a remote keyless entry system. In another example, the signaling device is part of a sensor arrangement (60) for monitoring a selected condition of at least one selected vehicle component (62).

## Description

### BACKGROUND OF THE INVENTION

This invention generally relates to transmitters used in vehicle control or monitoring systems. More particularly, this invention relates to a unique component arrangement for more efficiently radiating signals from a transmitter.

Remote keyless entry systems typically include a controller, located on a vehicle for example. A remote signaling transmitter provides signals to the controller indicating a desired operation. Many transmitters are embodied in key fobs or portable cards that are carried about by a user.

One challenge constantly facing those in this field is making efficient transmitters that fit within cost budgets and perform satisfactorily. Those skilled in the art are always striving to find ways to reduce power consumption while still providing adequate signal strength, for example.

One difficulty associated with conventional arrangements is that attempts to increase the signal strength of a transmitted signal typically requires larger power consumption or more robust components, both of which introduce undesirable expense into the system. Moreover, the nature of the components used in conventional remote keyless entry transmitters and their arrangement typically introduces harmonic variations whenever signal strength is adjusted outside of specific parameters. Therefore, it is difficult to enhance the operation of such a transmitter without, at the same time, introducing performance variation that must be compensated for using additional components or more expensive components.

The signal transmission problem described above is not limited to signaling used in remote keyless entry systems. The same challenges are faced by those attempting to incorporate various remote signaling devices on a vehicle. One example includes tire pressure sensors. The challenges of having a robust and reliable sensor and transmitter arrangement is further complicated by the presence of surrounding vehicle structure. An additional difficulty is overcoming the variations in signal power caused by rotation of the wheels while the vehicle is in motion.

This invention addresses the need for enhancing the performance of a signaling transmitter without introducing additional cost into the system. A transmitter designed according to this invention provides more efficient operation and reduced harmonic effects on the performance of the circuitry or components of the transmitter.

### SUMMARY OF THE INVENTION

In general terms, this invention is a remote signaling transmitter having an antenna directly coupled to an emitter of a transistor in the oscillator portion of the transmitter.

A transmitter designed according to this invention includes a signal source. An oscillator processes the signal from the signal source and puts it into a form that is suitable for transmission to a remotely located receiver. The oscillator includes a transistor having a base, collector and emitter. An antenna is directly coupled to the emitter of the transistor.

By directly coupling the antenna to the emitter, less current is required to achieve adequate radio frequency power for transmitting signals from a transmitter to a receiver. Because less current is required, greater signal strength is possible without introducing cost into the system or reducing the life of a battery of the transmitter. With an antenna coupled directly to an emitter, the antenna can have a greater mass, which makes the antenna a more efficient radiator and enhances the performance of the transmitter.

In one example, the transmitter is a part of a remote keyless entry system. In another example, the transmitter is a part of a tire pressure monitoring arrangement.

The various features and advantages of this invention will become apparent to those skilled in the art from the following detailed description of the currently preferred embodiment. The drawings that accompany the detailed description can be briefly described as follows.

### BRIEF DESCRIPTION OF THE DRAWINGS

Figure 1 schematically illustrates a vehicle including example systems having a transmitter designed according to this invention.

Figure 2 schematically illustrates selected portions of a transmitter designed according to this invention.

Figure 3 schematically shows a somewhat larger view of the portion of Figure 1 encircled at 3.

### DETAILED DESCRIPTION OF THE PREFERRED EMBODIMENT

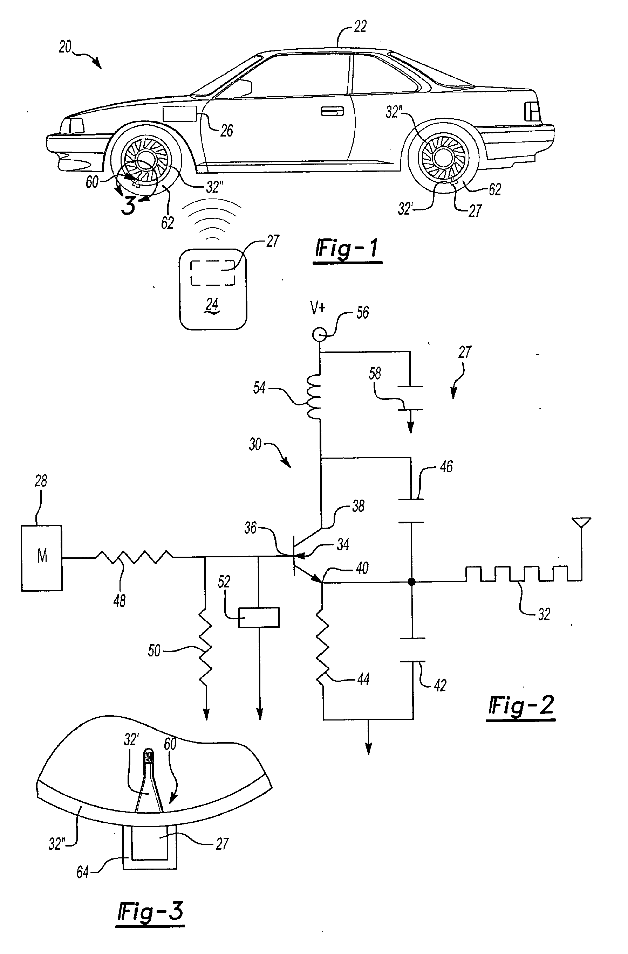

A remote signaling system 20 for a vehicle 22 includes a remote keyless entry portion and a vehicle component monitoring portion is shown in figure 1. In this particular example, the vehicle component monitoring portion includes a tire pressure monitoring arrangement.

The remote keyless entry portion includes a signaling device 24 that provides a signal to a controller 26 supported on the vehicle 22. The signaling device 24 has a transmitter 27, which in one example is embodied into a key fob that includes switches that are manually operated to generate signals indicating a desired operation to the controller 26. In another example (not shown), the signaling device 24 is a passive device embodied in a card that is portable, which includes the transmitter 27 that emits a signal without requiring manual activation by a user. A variety of signaling devices may be used within the scope of this invention.

The transmitter 27 preferably includes a microprocessor 28 (see figure 2) that performs various functions including providing a source signal for transmission by the transmitter 27. An oscillator 30, which in the illustrated example as shown in figure 2 is a Colpitts oscillator, processes a signal from the signal source 28 and puts it into a form that is suitable for being transmitted from the transmitter 27 to the controller 26. An antenna 32 effectively transmits the signal from the oscillator 30 such that the receiver portion of the controller 26 receives a recognizable signal. In one example, radio frequency signals are used.

The oscillator 30 includes a transistor 34 having a base 36, a collector 38 and an emitter 40. The antenna 32 is coupled directly to the emitter 40 of the transistor 34. This direct coupling provides substantial advantages compared to prior transmitter arrangements where the antenna 32 is coupled to another portion of the oscillator circuit. The arrangement of this invention provides for greater stability and better transmitter performance without introducing additional cost into the system. Having the antenna 32 directly coupled to the emitter 40 makes the transmitter 27 more efficient because less current is required to achieve higher signal strengths while simultaneously reducing the oscillator harmonics. Another advantage of this invention is that the rise time and fall time of the oscillator 30 are reduced. As known in the art, there is a delay between the actual signals transmission from the oscillator 30 compared to the source signal from the microprocessor 28. With the antenna 32 directly coupled to the emitter 40, the rise time and fall time of the oscillator 30 is reduced, which renders the performance of the transmitter 24 more accurate and reliable. Additionally, coupling the antenna 32 directly to the emitter 40 allows for greater variation in antenna design.

A transmitter designed according to this invention can include a much larger antenna 32 compared to previous designs. In one example signaling device 24 for remote keyless entry communications, the antenna 32 is a trace on a printed circuit board. Because of the direct coupling between the antenna 32 and the emitter 40, the typical LC factor introduced by the antenna is not present and the antenna 32 can have a much longer length or larger mass than was previously achievable. In prior designs, the length of the antenna was substantially limited by a requirement to reduce the inductance, which allows for a longer trace to keep the desired frequency.

A capacitive element 42 and a resistive element 44 are coupled in parallel between the emitter 40 and ground. Another capacitive element 46 preferably is coupled between the collector 38 and the capacitive element 42. The connection between the antenna 32 and the emitter 40 preferably is also coupled to a node between the capacitive elements 42 and 46. The capacitive element 42 preferably is provided to sharpen the bit width and to provide signal control on the feedback loop back to the base 36 of the transistor 34. The capacitive element 46 preferably is provided to stabilize the oscillator performance.

A voltage divider circuit comprising resistors 48 and 50 preferably is included to provide temperature stability to the transmitter 27. Another element 52 preferably is provided to prevent harmonics in the feedback signals of the oscillator 30. In one example, the element 52 is a capacitor. In another example, the element 52 is a SAW oscillator.

The illustrated example includes an inductive element 54 coupled between the collector 38 of the transistor 34 and a voltage source 56, which is a battery. The inductive element 54 preferably is chosen to tune the oscillator 30. A capacitive element 58 preferably is coupled between the voltage source 56 and ground.

This invention is not limited to remote keyless entry system transmitters. Other signaling devices using remote communication (i.e., where signals are transmitted without using hard wired connections between a signal source and a signal destination) advantageously include the concepts of this invention.

A tire pressure sensing arrangement 60 as shown in figure 3 includes a transmitter portion 27 preferably designed as discussed above. The sensor arrangement 60 provides remote signals to the controller 26 indicating pressure or other selected conditions of the vehicle tires 62. A sensor 64 preferably is positioned relative to the tire 62 to acquire the data necessary to provide the desired information. The transmitter portion 27 preferably is supported relative to the valve stem 32' of the wheel so that the valve stem 32' operates as the antenna of the transmitter portion 27. Additionally, the wheel rim 32" serves as the antenna. In one example, the material characteristics of the valve stem 32' and the wheel rim 32" and the conventional arrangement of the stem and rim provide a sufficient electrical connection such that the valve stem and wheel rim are electrically coupled and both operate as the antenna or radiator of the transmitted signal. In one example, only the wheel rim 32" operates as the antenna.

The valve stem 32' and the wheel rim 32" preferably are directly coupled to the emitter 40 of the transistor 34 so that the advantages of this invention are achieved. Utilizing the entire wheel rim 32" as an antenna becomes possible when incorporating the concepts of this invention. Utilizing the entire wheel rim 32" as an antenna provides substantial advantages because the signal transmission problems associated with prior tire sensor arrangements are avoided (such as a loss of signal strength as the sensor and its associated antenna rotate while the vehicle is moving). Having the larger mass of the wheel rim 32" provides stronger signals. Moreover, having the entire wheel rim 32' serve as an antenna eliminates unwanted variations in the signal communicated from the sensor 64 to the controller 26.

The various components of the example embodiments of this invention such as the controller 26, sensor 64 and signaling device 24 are schematically illustrated. Those skilled in the art who have the benefit of this description will be able to select from among commercially available components or to custom design components such that they operate according to this description.

The preceding description is exemplary rather than limiting in nature. Variations and modifications to the disclosed example may become apparent to those skilled in the art.

## Claims

1. A transmitter (27) for use in a remote signaling system (20), comprising:
a signal source (28);
an oscillator (30) that puts a signal from the signal source (28) into a transmittable form, the oscillator (30) including a transistor (34) having an emitter (40); and
an antenna (32) that is coupled directly to the transistor emitter (40), the antenna (32) transmitting the oscillator signal.

2. The transmitter (27) according to claim 1, wherein the antenna (32) comprises a trace on a printed circuit board.

3. The transmitter (27) according to claims 1 or 2, wherein the oscillator (30) comprises a Colpitts oscillator.

4. The transmitter (27) according to anyone of the preceding claims, including a first capacitive element (42) in parallel with a resistive element (44) both coupled between the emitter (40) and ground.

5. The transmitter (27) according to claim 4, including a second capacitive element (46) in series with the first capacitive element (42) between the first capacitive element (42) and the collector (38) of the transistor (34) and wherein the coupling between the antenna (32) and the emitter (40) is also coupled between the first and second capacitive elements (42, 46).

6. The transmitter (27) according to anyone of the preceding claims, including a voltage source (56) and an inductive element (54) coupled to the collector (38) of the transistor.

7. The transmitter (27) according to anyone of the preceding claims, wherein the antenna (32) comprises at least a portion (32',32") of a wheel.

8. A remote keyless entry system (20), comprising:
a controller (26) that performs an action based upon a received signal; and
a transmitter (27) that remotely transmits a signal to the controller (26), the transmitter (27) including a signal source (28), an oscillator (30) that puts a signal from the signal source (28) into a transmittable form and includes a transistor (34) having an emitter (40), and an antenna (32) that is coupled directly to the transistor emitter (40), the antenna (32) transmitting the oscillator signal.

9. The system (20) according to claim 8, wherein the antenna (32) comprises a trace on a printed circuit board.

10. The system (20) according to claim 8 or 9, wherein the oscillator (30) comprises a Colpitts oscillator.

11. The system (20) according to anyone of claims 8 to 10, including a first capacitive element (42) in parallel with a resistive element (44) both coupled between the emitter (40) and ground.

12. The system (20) according to claim 11, including a second capacitive element (46) in series with the first capacitive element (42) between the first capacitive element (42) and the collector (38) of the transistor (34) and wherein the coupling between the antenna (32) and the emitter (40) is also coupled between the first and second capacitive elements (42,46).

13. A vehicle component monitoring system (60), comprising:
a controller (26) supported on the vehicle (22) that receives and interprets signals indicating a condition of at least one selected vehicle component (62); and
a sensor device (64) associated with the selected vehicle component (62) that remotely transmits a signal to the controller (26), the sensor device (64) including a signal source (28), an oscillator (30) that puts a signal from the signal source (28) into a transmittable form and includes a transistor (34) having an emitter (40), and an antenna (32,32',32'') that is coupled directly to the transistor emitter (40).

14. The system (60) according to claim 13, wherein the antenna (32) comprises a valve stem (32') on a vehicle wheel.

15. The system (60) according to claim 13 or 14, wherein the antenna (32) comprises a rim (32") of the vehicle wheel.

16. The system (60) according to anyone of claims 13 to 15, wherein the oscillator (30) comprises a Colpitts oscillator.
